# EUROPEAN PATENT APPLICATION

(11) **EP 0 989 676 A1**
(43) Date of publication of application: **29.03.2000**
(21) Application number: 99307239.6
(22) Date of filing: 14.09.1999
(51) Int. Cl.: H03L 7/113

(54) **Frequency presetting device for a voltage controlled oscillator**

(30) Priority: 21.09.1998 EP 98460039
(71) Applicant: TRT Lucent Technologies (SA), 92359 Le Plessis Robinson (FR)
(72) Inventor: Laffont, Jean, 78530 Bois d'Arcy (FR)
(74) Representative: Williams, David John

(57) **Abstract**

This invention relates to a frequency presetting device for a voltage controlled oscillator (VCO) including a servocontrol loop (ASS). This device is designed to preset the said voltage controlled oscillator (VCO) within a frequency range [f1, f2], where f1 < f2, corresponding to the correct operating range of the said servocontrol loop of the said oscillator. It is characterized in that it comprises first and second means (M1, M2) forming first and second phase locking loops with the said voltage controlled oscillator, the said first and second phase locking loops being designed to lock the voltage controlled oscillator on frequencies fl and f2 respectively, the said first means (M1) comprising means of deactivating the first locking loop when the frequency of the voltage controlled oscillator (VCO) is greater than or equal to fl, and the said second means (M2) comprising means of deactivating the second locking loop when the frequency of the voltage controlled oscillator (VCO) is less than or equal to f2.

Applications: coherent demodulation, Costas loops, etc.

## Description

This invention relates to a device for frequency presetting of a voltage controlled oscillator.

Voltage Controlled Oscillators, better known as VCOs, are very frequently used in coherent phase demodulation devices such as Costas loop circuits, for extracting the carrier. The voltage controlled oscillator in this type of device is servocontrolled by a servocontrol loop. If the device is to operate correctly as soon as it is switched on, it is usually necessary to preset the frequency of the voltage controlled oscillator over a relatively narrow frequency range [f1, f2] corresponding to the operating range of the servocontrol loop.

One way of avoiding this presetting operation would be to use a voltage controlled oscillator that is intrinsically stable at different temperatures and with time (aging), in which the free frequency f0 would be close to the range [f1, f2]. Nevertheless, it has been found that this type of oscillator is particularly difficult to design for higher values of frequencies f1, f2 and when the digital output of the signal is weak. Consequently, this type of oscillator is very difficult to reproduce. Devices also exist for searching for the pickup range of the servocontrol loop of the system which consists of applying a voltage ramp to the control input of the voltage controlled oscillator. However, this type of device introduces risks of false latching at frequencies other than frequency f0, for which the phase comparator of this device is particularly sensitive.

There are also other frequency presetting devices using a phase locking loop to lock the voltage controlled oscillator onto a frequency f between f1 and f2. However, once the locking frequency has been reached, the phase locking loop does not "cut off" naturally and a relatively complex system is necessary to cut off the phase locking loop and to switch the oscillator to the servocontrol loop.

This invention is thus designed to overcome these disadvantages of prior art, by proposing a presetting device that is automatic and easy to use.

Therefore, the purpose of the invention is a frequency presetting device for a voltage controlled oscillator including a servocontrol loop, the said device being designed to preset the said voltage controlled oscillator within a frequency range [f1, f2] where f1 < f2 corresponding to the correct operating range of the said servocontrol loop of the said oscillator, and it is characterized in that it comprises first and second means forming first and second phase locking loops with the said voltage controlled oscillator, the said first and second phase locking loops being designed to lock the voltage controlled oscillator on frequencies f1 and f2 respectively, the said first means comprising means of deactivating the first locking loop when the frequency of the voltage controlled oscillator is greater than or equal to f1, and the said second means comprising means of deactivating the second locking loop when the frequency of the voltage controlled oscillator is less than or equal to f2.

Thus, when the frequency of the voltage controlled oscillator is within the interval [f1, f2], the action of the two phase locking loops on the voltage controlled oscillator is interrupted.

In one preferred embodiment, the first means comprises:
- a first comparison module that compares the frequency of the voltage controlled oscillator with the frequency f1 and outputs a positive control voltage to the voltage controlled oscillator when the oscillator frequency is less than f1, and
- a first diode inserted between the first comparison module and the voltage controlled oscillator, the said first diode being polarized so that it is blocked and deactivating the first phase locking loop when the frequency of the voltage controlled oscillator is greater than or equal to f1,
and in that the second means comprises
- a second comparison module to compare the frequency of the voltage controlled oscillator with the frequency f2, outputting a positive control voltage to the voltage controlled oscillator when the oscillator frequency is less than f2, and
- a second diode inserted between the second comparison module and the voltage controlled oscillator, the said second diode being polarized so that it is blocked and deactivating the first phase locking loop when the frequency of the voltage controlled oscillator is less than or equal to f2.

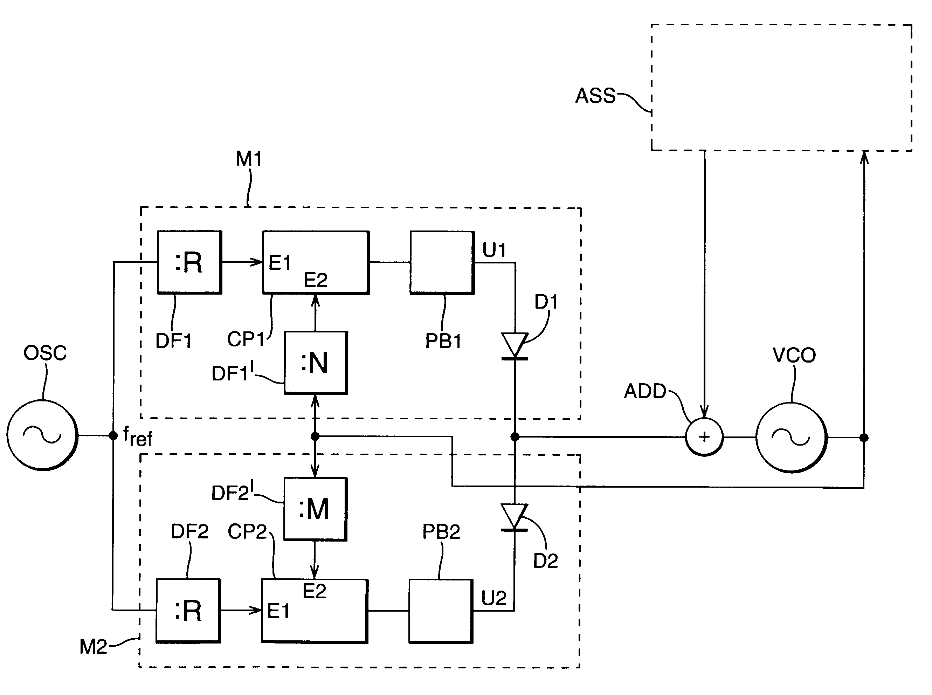

Other characteristics and advantages of the invention will become obvious in reading the detailed description given below and which refers to the figure attached which represents a diagram of a frequency presetting device according to the invention.

The voltage controlled oscillator according to the invention is inserted in two phase locking loops acting on the oscillator control input when the frequency of its output signal is outside the interval [f1, f2], where f1 < f2.

One embodiment of the frequency presetting device according to the invention is shown in the single figure provided. The voltage controlled oscillator, VCO, for which the frequency is to be set is used in a servocontrol loop ASS, for example a Costas loop.

The device according to the invention comprises first and second means M1, M2, that form the first and second phase locking loops PLL1 and PLL2 respectively, with the voltage controlled oscillator, VCO. The phase locking loop PLL1 acts on the control input of oscillator VCO when the frequency f of the signal output from the oscillator is less than fl, unlike the phase locking loop PLL2 that contributes to control of oscillator VCO when the frequency f exceeds f2.

Means M1 comprises a phase/frequency comparator CP1, in which a first input E1 is connected to the output of an oscillator OSC that outputs a frequency reference signal f_{ref} through a first frequency divider DF1, and in which a second input E2 is connected to the output of oscillator VCO through a second frequency divider circuit DF1'. In this example, the divider DF1 divides the frequency f_{ref} by R, whereas the divider DF1' divides the frequency f of the output signal of oscillator VCO by N. Therefore the loop PLL1 is designed to lock on frequency f1 = N.f_{ref}/R. The comparator CP1 output is connected to a low pass filter PB1 that only allows the DC component U1 of the signal output from comparator CP1 to pass. This DC voltage U1 is then added using an adder circuit ADD to the voltage output from the servocontrol loop ASS, and the resulting voltage is then applied to the control input of oscillator VCO.

Means M1 is used with a diode D1 that is inserted between filter PB1 and adder ADD, so that this phase locking loop will act on the oscillator VCO only when f > f1. This diode is polarized so that it is blocked when f > f1. Consequently, its anode is connected to the output of filter PB1 and its cathode is connected to one of the inputs of adder ADD.

The structure of means M2 forming a second phase locking loop PLL2 with the oscillator VCO is globally the same as the structure of means M1. It comprises a phase/frequency comparator CP2, in which the input E1 is connected to the output of the oscillator OSC through a frequency divider DF2, and in which the input E2 is connected to the output of the oscillator VCO through a frequency divider DF2'. The frequency dividers DF2 and DF2' perform a division by R and by N respectively. The loop PLL2 is designed to lock on frequency f2 = N.f_{ref}/R. The comparator output CP2 is connected to a low pass filter PB2 that only allows the DC component U2 of the signal output from comparator CP2 to pass. This DC component is then added using the adding means ADD to the voltage output from the servocontrol loop ASS, and the resulting voltage is then applied to the control input of oscillator VCO.

This second locking loop is designed to operate only when f > f2. The means M2 is also supplied with a diode D2 inserted between the filter PB2 and the adder ADD. This diode is polarized such that it is blocked when f < f2. This is why its cathode is connected to the output from filter PB2 and its anode is connected to one of the inputs of adder ADD.

The device operates as follows:
- when f < f1 = N.f_{ref}/R, the DC voltage U1 output from filter PB1 is positive; diode D1 is then conducting; the DC voltage U2 output from filter PB2 is also positive since f1 < f2; however, since the diode D2 is inversely polarized, the diode is consequently blocked; thus, the oscillator VCO is controlled only by means M1, which acts such that the phase locking loop PLL1 thus formed locks onto frequency f1;
- when f1 ≤ f ≤ f2, voltage U1 is negative or zero and voltage U2 is positive or zero; consequently, diodes D1 and D2 are blocked; the voltage controlled oscillator VCO is controlled only by the servocontrol loop ASS;
- finally when f > f2, the DC voltages U1 and U2 are negative; diode D1 is blocked and diode D2 is conducting; means M2 thus acts on the control of oscillator VCO such that the phase locking loop PLL2 thus formed locks onto frequency F2.

With this very simple device, the frequency of the VCO output signal is always between f1 and f2, so that it can be servocontrolled by the ASS loop. Diodes installed inversely create a sort of "dead" zone within which the VCO oscillator is controlled only by the servocontrol loop ASS.

The locking frequencies f1 and f2 of the PLL1 and PLL2 loops can be adjusted by modifying the division factor of the frequency dividers in the device and/or by modifying the frequency f_{ref} of the oscillator OSC. Obviously, when the division factor is the same for dividers DF1 and DF2, as is in the case here, it is possible to use a single frequency divider placed at the output from oscillator OSC.

## Claims

1. Frequency presetting device for a voltage controlled oscillator (VCO) including a servocontrol loop (ASS), the said device being designed to preset the said voltage controlled oscillator (VCO) within a frequency range [f1, f2] where f1 < f2 corresponding to the correct operating range of the said servocontrol loop of the said oscillator, and it is characterized in that it comprises first and second means (M1, M2) forming first and second phase locking loops with the said voltage controlled oscillator (VCO), the said first and second phase locking loops being designed to lock the voltage controlled oscillator on frequencies f1 and f2 respectively, the said first means (M1) comprising means of deactivating the first locking loop when the frequency of the voltage controlled oscillator (VCO) is greater than or equal to f1, and the said second means (M2) comprising means of deactivating the second locking loop when the frequency of the voltage controlled oscillator (VCO) is less than or equal to f2.

2. Device according to claim 1, characterized in that the first means (M1) comprises
- a first comparison module (CP1, DF1, DF1', PB1) that compares the frequency of the voltage controlled oscillator (VCO) with the frequency f1 and outputs a positive control voltage to the voltage controlled oscillator when the oscillator frequency is less than f1, and
- a first diode (D1) inserted between the first comparison module and the voltage controlled oscillator, the said first diode being polarized so that it is blocked and deactivating the first phase locking loop when the frequency of the voltage controlled oscillator is greater than or equal to f1,
and in that the second means (M2) comprises
- a second comparison module (CP2, DF2, DF2', PB2) to compare the frequency of the voltage controlled oscillator (VCO) with the frequency f2, outputting a positive control voltage to the voltage controlled oscillator when the oscillator frequency is less than f2, and
- a second diode (D2) inserted between the second comparison module and the voltage controlled oscillator, the said second diode being polarized so that it is blocked and deactivating the first phase locking loop when the frequency of the voltage controlled oscillator is less than or equal to f2.
